# EUROPEAN PATENT SPECIFICATION

(11) **EP 1 537 602 B1**
(45) Date of publication and mention of the grant of the patent: **16.05.2007**
(21) Application number: 03791132.8
(22) Date of filing: 31.07.2003
(51) Int. Cl.: H01L 27/146

(54) **IMAGE SENSOR, CAMERA SYSTEM COMPRISING THE IMAGE SENSOR**
BILDSENSOR, KAMERASYSTEM MIT DEM BILDSENSOR
CAPTEUR D'IMAGE, SYSTEME DE CAMERA COMPORTANT CE CAPTEUR D'IMAGE

(30) Priority: 30.08.2002 EP 02078601
(43) Date of publication of application: 08.06.2005
(73) Proprietor: Koninklijke Philips Electronics N.V., 5621 BA Eindhoven (NL)
(72) Inventor: FOLKERTS, Hein, O., NL-5656 AA Eindhoven (NL); MAAS, Joris, P., V., NL-5656 AA Eindhoven (NL); VERBUGT, Daniel, W., E., NL-5656 AA Eindhoven (NL); LUKIYANOVA, Natalia, V., NL-5656 AA Eindhoven (NL); HERMES, Daniel, H., J., M., NL-5656 AA Eindhoven (NL); HOEKSTRA, Willem, NL-5656 AA Eindhoven (NL); MIEROP, Adrianus, J., NL-5656 AA Eindhoven (NL)
(74) Representative: Eleveld, Koop Jan
(86) International application number: PCT/IB2003/003752
(87) International publication number: WO 2004/021444

(56) References cited:
- EP-A- 1 231 642
- US-B1- 6 392 263

## Description

The invention relates to an image sensor comprising a semiconductor body having a first conductivity type and having a surface, the surface being provided with a number of cells, a cell comprising a photosensitive element and a reset transistor, the reset transistor comprising a source region, a drain region and a gate region, the source region and the drain region having a second conductivity type opposite to the first, the source region of the reset transistor being electrically connected to the photosensitive element.

The invention further relates to a camera system comprising the image sensor.

It is described a method of manufacturing a CMOS image sensor comprising the steps of:
- forming a photosensitive element in a semiconductor substrate having a first conductivity type by providing dopant atoms into a region in the semiconductor substrate, the dopant atoms having a second conductivity type in the region opposite to the first conductivity type,
- using a protection mask over the region of the photosensitive element after which a well region is formed by implanting ions having a first conductivity type in the semiconductor substrate,
- forming a gate region by depositing a layer of gate material and patterning the layer.

US-A 6,177,293 discloses a method for forming a CMOS image sensor that minimizes the occurrence of white pixels in images. In the method, field oxide surrounding the photosensitive region of a cell is formed with interior angles greater than 90 degrees and/or is continuously curved. In this way mechanical and electrical stress in the field oxide surrounding the photosensitive region of the cell is minimized. Regions subjected to excessive mechanical stress during fabrication, and regions subjected to excessive electrical stress during device operation show excessive current leakage. In order to be less sensitive to these regions subjected to stress, the reset gate has an offset from the photosensitive regions of active pixel cells by a distance greater than 0.25 µm.
It has been determined that excessive current leakage from the photosensitive (e.g., photodiode) regions is a significant cause of white pixel problems in CMOS image sensors.

Document US 6392263 discloses a CMOS pixel having a photodiode formed by a n-well surrounded by a p-well. The disavantage of the dired contact between the n- and p- well is that it contributes to the total photodiode dark current and consequently, the fixed pattern noise is increased.

It is a problem that despite the measures indicated above, there are still large numbers of white pixels in CMOS image sensors. White point defects or spots visible on the display or monitor are the result of a local charge carrier generation site that in all cases causes additional charge carriers in the charge packet integrated near it.

Moreover, the variance in dark current between the pixels in the image, called fixed pattern noise, is a major problem. The dark current generation is hardly uniform from cell to cell. The generation centers of the dark current are statistically distributed through the semiconductor. This means that not all cells have the same number of generation centers. On the other hand the generation rate of each center can also vary from type to type. All these variations make the dark current no longer uniform. Non-uniform dark-current generation adds fixed pattern noise to the signal. Fixed pattern noise is very hard to remove. This is only possible if the distribution of this non-uniform spurious signal is known.

The invention has for its object to provide an image sensor of the type mentioned above, having a reduced number of white pixels and a reduced fixed pattern noise.

To achieve the object, the image sensor according to the invention is characterized in that the photosensitive element is a photodiode formed by a doped region having a second conductivity type surrounded by the semiconductor body having the first conductivity type and there is a separation distance between the doped region and the well region, the separation distance being formed by the semiconductor body.

A significant contribution to white pixels and fixed pattern noise (FPN) originates from the source diffusion of the MOS field effect transistor (MOSFET) connected to the photosensitive element. The invention is based on the insight that the white pixels and fixed pattern noise are mainly caused by the source-well junction. This junction causes large leakage currents due to tunneling of charge carriers through the depletion layer. The tunnel current can be a trap assisted tunnel current or a direct tunnel current. Leakage currents due to tunneling in the source-well junction can be distinguished from regular Shockly-Read-Hall recombination by the exponential behavior of the current as a function of the voltage applied across the junction. A correlation has been found between the exponential behavior of the leakage current in the source-well junction, the number of white pixels and the fixed pattern noise.

By positioning the source region substantially in the doped region of the photosensitive element, the source-well junction area is reduced and therefore the number of white pixels and FPN are reduced. The leakage current due to the junction between the source-photosensitive element is almost negligible because the source region and the doped region of the photosensitive element have the same conductivity type.

Preferably, the concentration of dopant atoms of the semiconductor body is present below the source. The relatively low concentration of the semiconductor body forms a junction with the bottom area of the source. The width of the depletion layer is large, mainly extending in the semiconductor body. The contribution of leakage current resulting in white pixels and FPN from this bottom area is negligible.

It is very advantageous to position the side-wall of the well at a certain distance from the source to reduce significantly the tunneling currents. This can be explained because the separation distance between the source and the well increases the depletion layer width. In fact the increase in depletion layer width is roughly equal to the separation distance. Because of the larger depletion width, the number of white pixels and the fixed pattern noise decreases. It is desirable to have a well at the drain side. The well reduces short channel effects, drain induced barrier lowering and punch through.

It is very advantageous to position the side-wall of the well under the gate. The laterally out-diffused region of the well has a lower dopant concentration than in the center of the well. Due to this lower dopant concentration, the depletion layer width between the source and the well becomes larger and extends more in the well. The peak of the electrical field is reduced as well as the gradient in the electrical field in the well. The lower dopant concentration in the source side of the well causes a higher absolute value of the threshold voltage. This increase in the absolute value of the threshold voltage can be compensated with a longer gate length.

In contradiction to what has been found in the prior art, it is advantageous to position the gate along the edge of the photosensitive element so that the source region extends entirely into the doped region of the photosensitive element. In that case the source-well junction area is minimized. By doing this, all charge is effectively gathered in the source and can easily be transported by putting a voltage on the gate of the reset transistor to form a channel. The well extends from an edge of the photosensitive element in the outer direction and contributes to the depletion layer of the photosensitive element. When light falls on the photosensitive element, electron-hole pairs are generated. Due to the electrical field in the depletion layer, the electron-holes pairs are separated in the depletion layer of the photosensitive element. The charge carriers of the second conductivity type, e.g. electrons, are accelerated in the direction of the highly doped source. As long as the reset transistor is closed, charge is gathered on the source. After some time, for instance 10 ms, a voltage is set on the gate and the reset transistor opens. The charge can easily be transported through the channel of the reset transistor.

Two different types of sensors can be realized in CMOS technology. These are passive and active pixel sensors (APS). The difference between these two types is that a passive pixel does not perform signal amplification whereas an active pixel does. A passive pixel sensor is simply a photodiode (MOS or p-n junction diode) with a transistor that passes photoelectrically generated signal charge to an amplifier outside the pixel array. In an active pixel, the integrated charge is amplified by a source follower transistor and transported in the channel of the reset transistor. The gate of the source follower transistor is connected to the source of the reset transistor.

When the length of the gate of the reset transistor is the same as the length of the gate of the source follower, the absolute value of the threshold voltage of the reset transistor will be lower than for the source follower transistor. The well of the reset transistor is only partly present below the gate of the reset transistor, so that the concentration of the dopant atoms is lower than below the gate of the source follower transistor. In order to compensate the lower absolute value of the threshold voltage of the reset transistor, the length of the gate of the reset transistor is increased. So it is advantageous to design the length of the gate of the reset transistor longer than the length of the gate of the source follower transistor.

The active pixel image sensor may be part of a camera system, for example a Digital Still Camera, a webcam, a video camera recorder (camcorders), or a mobile application such as a cellular phone.

It is further an object of the method of the kind mentioned above to reduce the number of white pixels and the fixed pattern noise without using additional mask steps in a standard CMOS process.

To achieve the object, the method of manufacturing the image sensor not making part of the invention is characterized in that the gate region is formed over a side-wall of the well region, the side-wall being present between the region of the photosensitive element and the well region.

An example is further based on the insight that the implantation of ions of the second conductivity type, forming the photosensitive element, introduces end of range damage in the semiconductor substrate and metal atoms. These metal atoms like Fe, Au, Pt are traps in the bandgap of the semiconductor substrate. If the metal atoms are located in the depletion layer between the implanted region forming the photosensitive element and the well, then they can be responsible for a trap assisted tunneling current. Electrons can tunnel to the trap, recombine with a hole, giving rise to a larger number of white spots and a larger fixed pattern noise. The trap assisted tunneling current increases when there is a voltage applied over the depletion layer.

In order to circumvent this trap assisted tunnel current, the gate is formed over a side-wall of the well. The well is retracted over a distance relative to the gate length. Now there is a separation distance between the implanted region of the photosensitive element and the well. Due to this separation distance, the depletion layer is so large that only Shockley Read Hall recombination can take place and trap assisted tunneling currents no longer contribute. Moreover, the depletion layer is formed between the implanted region and the semiconductor substrate, having a lower dopant concentration than the well. Therefore, the leakage current is reduced, resulting in a reduced number of white spots and a reduced fixed pattern noise.

Preferably the source region is formed self-aligned to the gate and is positioned at least substantially in the implanted region of the photosensitive element. Because the source has the same conductivity type as the photosensitive elements, the leakage currents are almost negligible.

Usually a source region and a drain region is formed by implanting ions of a second conductivity type self-aligned to the gate. It is very advantageous when there is a distance between the source and the well. The source is highly doped. The source-well junction causes tunneling currents. These tunneling currents can be trap assisted tunneling currents or direct tunneling currents through the depletion layer. The spacing reduces the dopant concentration and therefore increases the depletion layer width. The distance between the source and the well effectively increases the depletion layer width. The distance should be chosen such that the depletion width is too large at the operation voltages for trap assisted tunneling currents to occur. In silicon trap assisted tunneling can occur when the depletion layer width is smaller than about 40 nm. For direct tunneling the depletion layer should be smaller than about 25 nm.

It is advantageous when the field isolation is formed on the semiconductor substrate and the photosensitive element is formed by implantation of the ions of the second conductive type through the field isolation. The surface of the light sensitive element is no longer the silicon substrate, but the bottom of the field isolation. The field isolation can be a silicon oxide formed in a LOCOS process. The number of dangling bonds that is usually present at the surface of the semiconductor surface can be reduced. Below the field oxide, the silicon forms SiO₂ bonds so that the leakage current can be reduce and the result is a reduced number of white spots and fixed pattern noise.

The photosensitive element has an edge formed by the field isolation. It is advantageous to position the gate along that edge so that the entire source region is located in the implanted region forming the photosensitive element. The source and the implanted region of the photodiode have the same conductivity type. The leakage current between the highly doped source region and the lower doped region is negligible. The bottom area of the source region of the reset transistor no longer contributes to the leakage current. Only the relative small side-wall of the source junction can contribute to the leakage current. The leakage current is significantly reduced as well as the number of white pixels and the fixed pattern noise.

These and other aspects of the invention will be apparent and elucidated with reference to the drawings described hereinafter.
Fig. 1 is a schematic diagram of a known image sensor;
Fig. 2 is an electrical circuit of a three-transistor cell of the known image sensor;
Fig. 3 is a schematic of the operation principle of a three-transistor cell.
Fig. 4a is a first embodiment of the photosensitive element and the reset transistor in top view not making part of the invention;
Fig. 4b is a cross-sectional view along the line A-A' in Fig. 4a.
Fig. 4c is a cross-sectional view along the line B-B' in Fig. 4a.
Fig. 5 is the leakage current in the junction between the n+ source and the p-well.
Fig. 6 is a distribution of the dark current of an image sensor having 480x 640 cells at elevated temperature.
Fig. 7a. is a second embodiment of the photosensitive element and the reset transistor in top view not making part of the invention.
Fig. 7b is a cross sectional view along the line A-A' in Fig. 7a.
Fig. 8a is a third embodiment of the photosensitive element and the reset transistor in top view not making part of the invention.
Fig. 8b is a cross sectional view along the line A-A' in Fig. 8a.
Fig. 9a is a fourth embodiment of the photosensitive element and the reset transistor in top view according to the invention.
Fig. 9b is a cross sectional view along the line A-A' in Fig. 9a.
Fig. 10 shows a histogram of the number of white pixels correlated with the leakage current for the different embodiments;
Fig. 11 is a method of manufacturing the image sensor according to the invention;
Fig. 12 is a simulation of the dopant profiles of the different embodiments.

Active pixel sensor (APS) imagers are usually realized as solid state imagers in a Complementary Metal-Oxide Semiconductor (CMOS) integrated circuit (IC) process. In normal use an APS imager may be part of a camera system, for example a Digital Still Camera, a webcam, a video camera recorder (camcorders), or a mobile application such as a cellular phone.

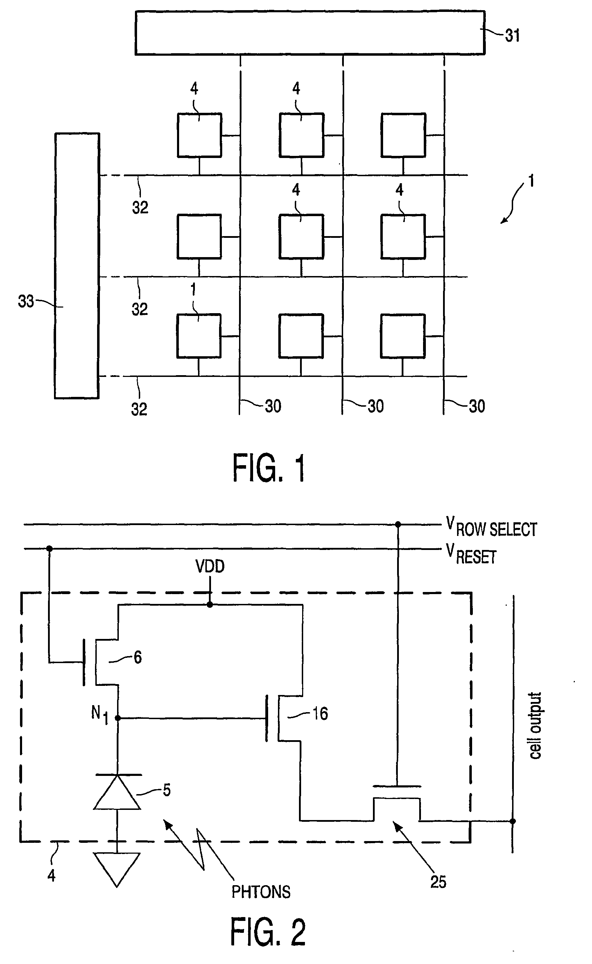

The image sensor in Fig. 1 comprises a number of cells 4 arranged in a two-dimensional pattern of horizontal rows and vertical columns. The cells are connected in a vertical direction to readlines 30. The readlines 30 pass the signals to a read-out element 31. In the horizontal direction the cells are connected to selection lines 32 via which selection signal can be sent to a row to be read out, which row is selected by addressing means 33. In the horizontal direction the cells can also be connected by horizontal reset lines that are not shown in the drawing.

The cells 4 are formed along the surface 3 of the semiconductor body 2, with each cell periodically generating a signal having a current or voltage level that is indicative of the intensity of light incident to that cell. A typical three-transistor cell that is used in current CMOS image sensors is shown in Fig. 2. Sensors that use this technology are often referred to as CMOS active pixel sensors (APS).

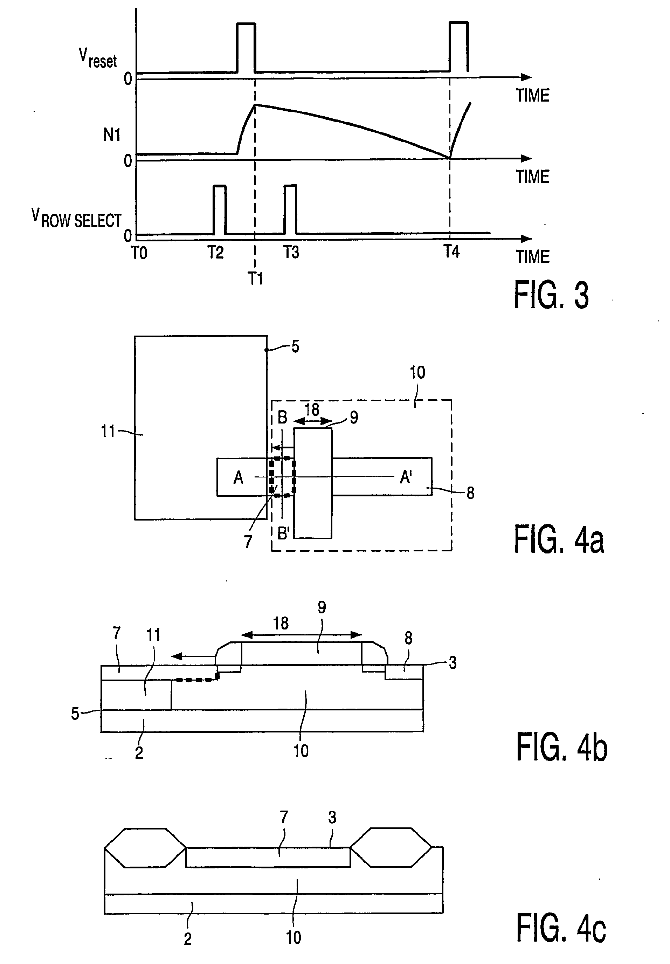

A timing diagram for the operation of the three-transistor cell 4 is shown in Fig. 3. In typical operation a node N1 is set to a predetermined Voltage Vdd' (which may be different from the circuit operating voltage Vdd) by turning on an n-channel reset transistor 6. The state of the reset transistor is determined by controlling a reset voltage (Vreset). In Fig. 3, Vreset goes high at time T0, causing the node N1 to ramp to Vdd'. At time T1, the reset transistor 6 is turned off and photoelectrons are generated by the incident light on a photosensitive element in the form of a photodiode 5. The photoelectrons are injected into node N1, reducing the voltage on that node by a value of Vsense=Vdd'- (Iₚₕₒₜₒ x Tᵢₗₗᵤₘᵢₙₐₜₑ/C_{N1}). In this equation Iₚₕₒₜₒ is the photocurrent induced by the incident light, Tᵢₗₗᵤₘᵢₙₐₜₑ is the illumination time period and C_{N1} is the capacitance on node N1. Both Vdd' and Vsense can in principle be read out of the pixel by a source follower transistor 16 by activating a row-select transistor 25. In a two-dimensional array of cells, there typically are row-select transistors and column-select transistors that allow the cells to be sequentially sampled. The row select transistor 25 is activated by manipulating a row-select signal. The illumination on the cell is then proportional to Vdd'-Vsense=Iₚₕₒₜₒ x Tᵢₗₗᵤₘᵢₙₐₜₑ/C_{N1}. Persons skilled in the art refer to this operation as Double Sampling. Sampling occurs at time T2 before Tᵢₗₗᵤₘᵢₙₐₜₑ and time T3 during Tᵢₗₗᵤₘᵢₙₐₜₑ. The cell is reset at time T4, since Vreset is caused to go high.

This sample technique can be used to remove several kinds of noise in high performance imaging systems. Double Sampling involves taking two samples of a sensor output. First, a reference sample is taken that includes background noise and noise derived from a device mismatch. Then a second sample is taken of the background noise, device mismatch, and the data signal. Subtracting the two samples removes any noise which is common (or correlated) to both, leaving only the data signal.

In silicon fabrication, an NMOS switching device with minimum size is normally used as the reset transistor in order to obtain minimum pixel size for good image resolution, and to minimize parasitic capacitances.

Fig. 4a gives a top view of an advantageous first embodiment of the photosensitive element 5 and the reset transistor 6 in the semiconductor body 2 not making part of the invention. The semiconductor body is in this embodiment a silicon substrate, but the semiconductor substrate is not limited to silicon and can be e.g. Ge or GaAs. The p-type silicon substrate is provided with an n-well. The n-well forms with the p-type substrate the photosensitive element in the form of a photodiode 5. The source- and drain regions of the reset transistor, in this example an n-channel transistor, are formed by the n-type zones 7 respectively 8 that are provided in the substrate.

There is a p-well region 10 present extending from the surface 3 into the semiconductor body 2. In this embodiment the p-well region 10 extends below the entire gate region 9. In deep-submicron CMOS transistors a well is necessary to reduce the sub-threshold voltage leakage current and compensate for short channel effects. Reverse biasing the back contact or bulk of a MOS transistor relative to the source is a method that has been employed to adjust the threshold potential. This electrical method of adjustment makes use of the so-called body effect or substrate-bias effect. In essence, back biasing changes the inversion point in the semiconductor from 2Φ_{F} to 2Φ_{F} - V_{BS}. Back-biasing always increases the absolute magnitude of the ideal device threshold voltage.

The tunneling currents can be reduced by decreasing the junction area between the n+-source 7 and the p-well 10. The junction between the p-well and the source is indicated with a thick dashed line. The n+-source area in the p-well is reduced by moving the gate of the reset transistor in the direction of the photodiode, as indicated with the arrow in Fig. 4a and Fig. 4b. The source region 7 extends at least substantially in a n-type doped region 11 of the photosensitive element 5. The junction between the n+-source and the n-well contributes to the dark current, but does not generate any tunneling currents.

In the cross-sectional view of Fig 4b the junction between the p-well 10 and the source 7 is again indicated with a thick dashed line. The total area of the junction between the p-well and the n-source determines largely the amount of tunnel currents. The dopant concentration in the source is typical 10²⁰ at/cm³ As or P. The p-well has a peak boron concentration of typically a few times 10¹⁷ at/cm³.

The higher the dopant concentrations in the n-type source and the p-well, the smaller the depletion layer width. For the typical dopant concentrations mentioned above, the depletion layer is about 46 nm. If there is no voltage applied to the source, then there is only Shockley- Read-Hall recombination in the depletion layer.

However, when a voltage is applied to the source (e.g. Vdd=3.3 V), the intrinsic electrical field increases in the source-well junction. The increased bending of the conduction and valence bands give rise to trap assisted tunneling currents. Most of the traps are metal atoms being present in the bandgap of silicon. It is believed that the traps are introduced during implantation steps.

An even further increase of the dopant concentration in the n-source or p-well can cause direct tunneling through the depletion layer.

The tunneling currents can be reduced by decreasing the junction area between the n-source and the p-well. The n+ source area in the p-well is reduced by moving the gate of the reset transistor in the direction of the photodiode, as indicated with the arrow in Fig. 4b.

The junction between the n+ source and the n-well contributes to the dark current, but does not generate any tunneling currents.

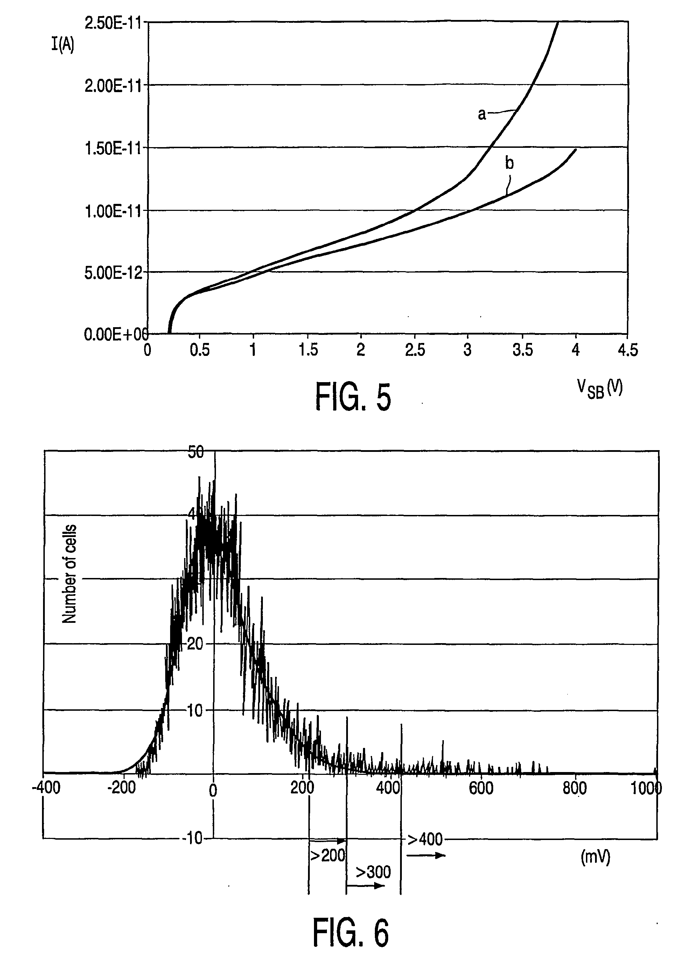

In Fig. 5 the leakage current is measured for the first embodiment having a relatively large p-well-n+ source junction area of 0.5 µm x 3 µm (curve a), and in the case that the junction area is reduced to 0.5 µm x 0.5 µm (curve b).

The reduction in leakage current is significant, especially at higher voltages, for example at 3V reverse bias.

It turned out that there is a clear correlation between the level and shape of the measured leakage current in the p-well- n+ source junction and the detected number of white pixels and fixed pattern noise in the pixels.

In Fig. 6, a distribution of the fixed pattern noise of the pixels in a 480x640 pixel image sensor is shown, measured at a temperature of 60 degrees C during an integration time of 330 ms. The integration time is chosen 10 times the normal integration time.

The measured output voltage shows a Gaussian distribution with a tail. When the output voltage is larger than 200 mV, the leakage current of the p-well-n+ source junction was high and showed an exponential increase above 3V.

When the output voltage is larger than 400 mV, the pixel is called a white spot.

The found correlation between the leakage current in the p-well - n+ source junction makes it possible to further reduce the number of white spots and reduce the fixed pattern noise.

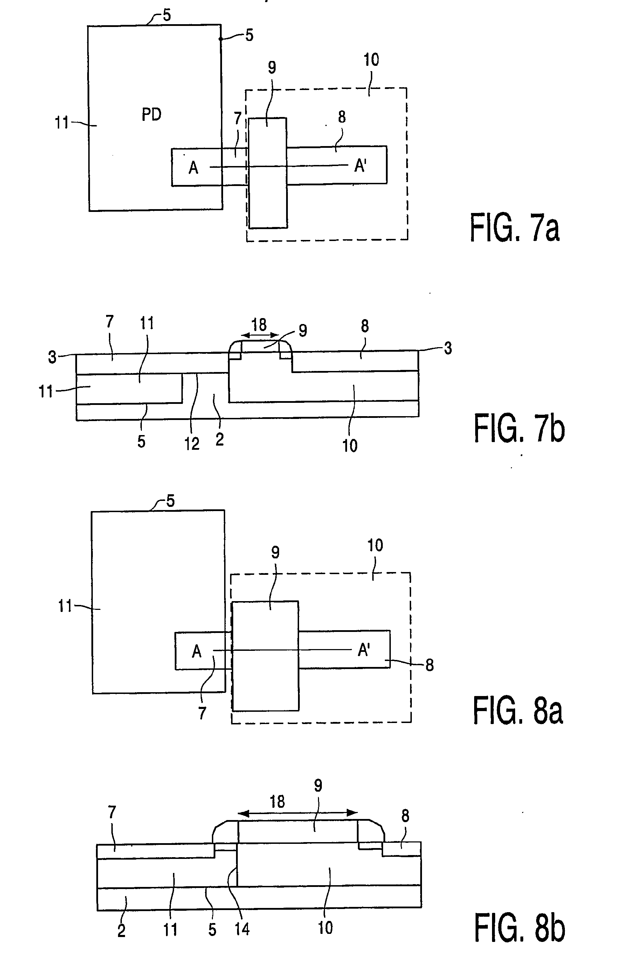

Fig. 7a shows a second advantageous embodiment in which the leakage current in the p-well-n source junction is reduced. In this example the p-well 10 is moved close to the gate 9 of the reset transistor. In the cross-sectional view of Fig. 7b can be seen that the p-type substrate 2 is present at the bottom 12 of the n+-source between the n-well 11 of the photodiode and the gate 9. The contribution of the n source- p-epi layer junction to the dark current is much less than for the n+ source- p-well junction. The n+ source area in the p-well is reduced.

In a third very advantageous embodiment of Fig. 8a the p-well 10 is aligned with the gate 9 and the entire n+-source 7 area is positioned in the n-well 11 of the photodiode.

The p-well- n+ source junction area is reduced to only the periphery of the source at the gate side. This configuration has the disadvantage that the threshold voltage of the MOS can change because the gate is positioned at the side-wall 14 of the p-well 10. The p-well is formed by implantation of boron and an anneal. The concentration of boron is near the side-wall 14 of the p-well 11 less than in the center of the p-well. The side-wall area of the p-well is formed by the laterally outdiffused boron atoms. There is a gradient in dopant concentration at the side-wall area of the p-well. The lower dopant concentration at the side-wall area of the p-well reduces the threshold voltage V_{T}.

The ΔV_{T} reduction in the threshold voltage of the reset transistor can be compensated by an increase in the length 18 of the gate of the reset transistor.

The decrease of the threshold voltage in the NMOS reset transistor as a function of gate length, called the V_{T} roll-off, can be easily measured. In the design, the gate length 18 of the reset transistor can be adapted to exactly compensate for the ΔV_{T} due to the lower dopant concentration at the edge of the p-well.

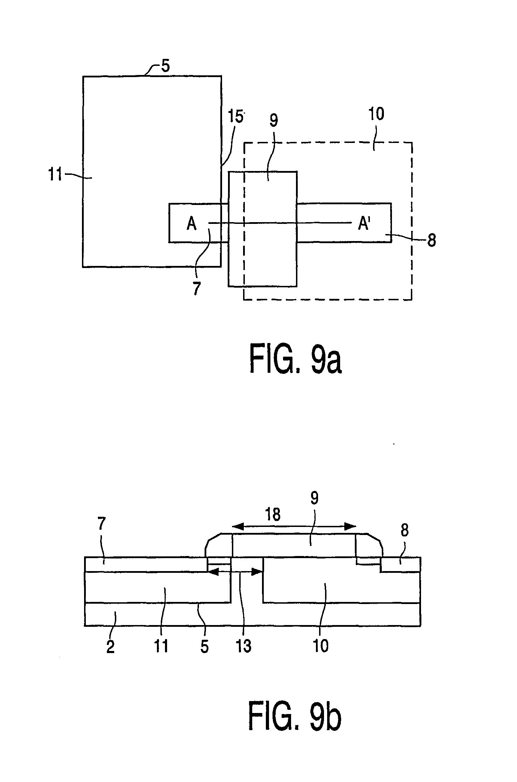

In a fourth embodiment of Fig. 9 the p-well 10 only extends partly below the gate 9. There is a distance 13 between the n+ source 7 and the p-well 10. Tunneling current in the n+-source- p-well junction area are completely eliminated.

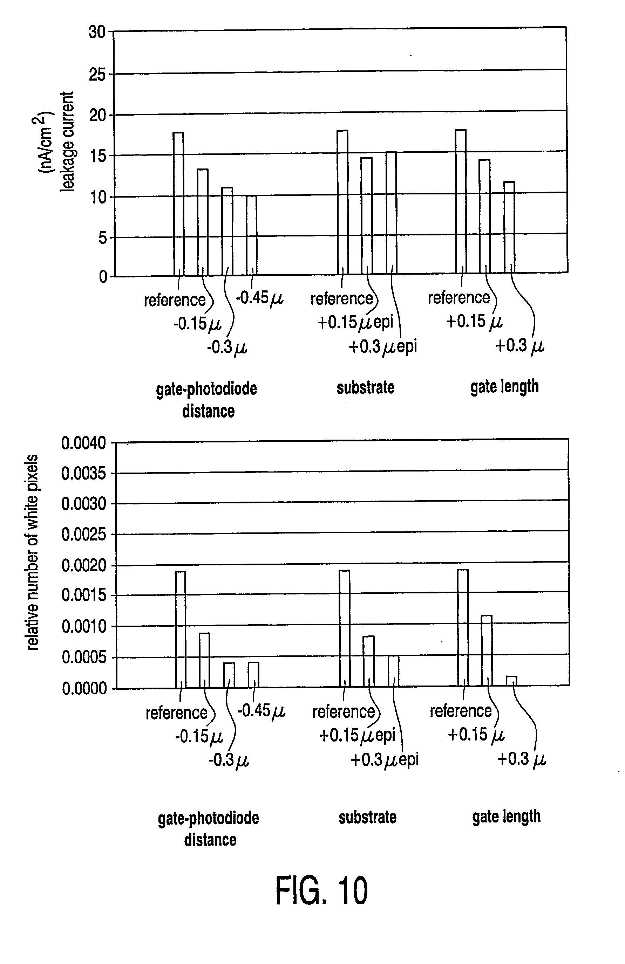

In Fig. 10 a clear correlation is shown between the leakage current in the n+-source- p-well diode and the relative number of white pixels in the 480x640 pixel image sensor. The number of white pixels is determined at a temperature of 60 degrees C. The reference situation is a reset transistor with a 0.5 µm gate length, a gate-photodiode distance of 1 µm and a substrate dopant concentration of 10¹⁴ at/cm³.

In the first embodiment the gate of the reset transistor is moved in the direction of the photodiode over a distance of 0.15 µm, 0.3 µm and 0.45 µm.

In the second embodiment the p-well is shifted towards the reset gate over a distance of 0.15 µm and 0.3 µm.

In the third embodiment the length of the reset gate is increased with 0.15 µm and 0.3 µm. The different variants in each embodiment are indicated in Fig. 10.

In the graph on top of the figure, the leakage current is shown in the n+-source-p-well junction measured at a reverse bias of 4.5 V. A clear correlation can be seen between the amount of leakage current in the n+-source-p-well junction and the relative number of white pixels shown in the histogram below. The lower the leakage current in each embodiment, the lower the number of white pixels observed.

The best result concerning white pixels is found for the third embodiment, having a longer reset gate. From Fig. 10 it is clearly shown that in all the embodiments the number of white pixels is significantly reduced.

It has also been found that the leakage current measured at a reverse bias (e.g. at 2.1V) shows a correlation with the width of the Gaussian distribution of the dark current (see for instance Fig. 6). The fixed pattern noise therefore also depends on the source- p-well leakage current.

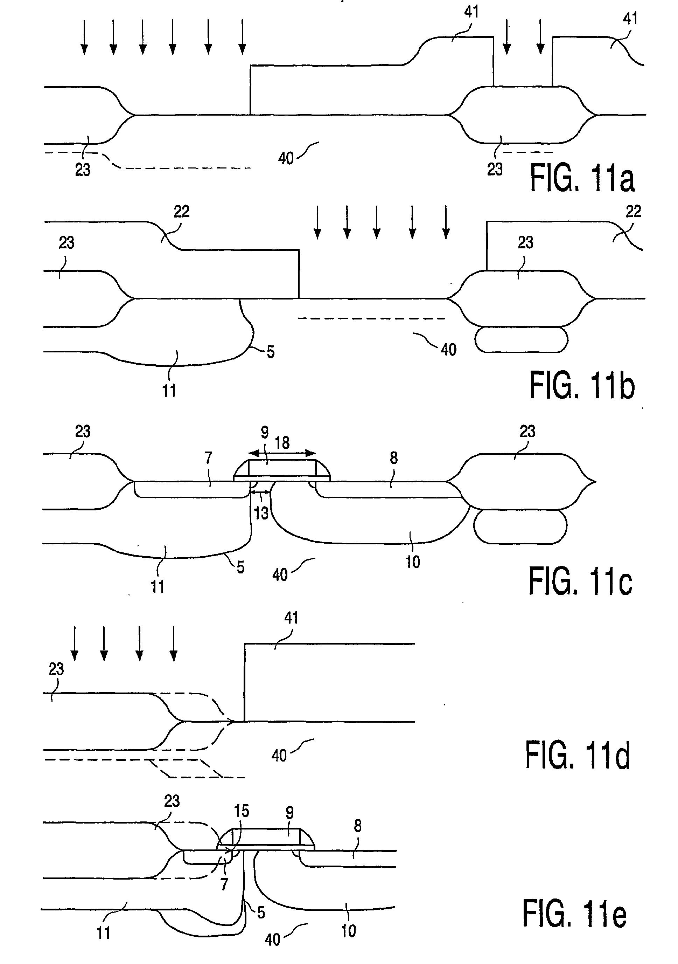

In an advantageous method of manufacturing a CMOS image sensor a p-type silicon substrate 40 is used. Field isolation regions 23 are formed with a poly buffered LOCOS process as shown in Fig. 11 a. In a resist mask 41 openings are present through which P ions are implanted with a dose of 10¹³ at/cm² at an energy of 500 keV. This implantation is identical to the n-well implantation in the CMOS process. Through the same mask openings an anti punch through implantation and a threshold voltage implantation follow.

The resist mask is removed and a protection mask 22 is used covering the n-well regions 11. The protection mask is in this embodiment a resist mask, having openings in order to implant a p-well as shown in Fig. 11 b. The protection mask can also be a hard mask e.g. formed of silicon oxide or silicon nitride.

The p-well 10 is implanted with B ions with a dose of 6x10¹² at/cm² at an energy of 160 keV. The protection mask 22 is also used during the anti punch through implantation and the threshold voltage implantation in the p-well.

The protection mask 22 is removed and the dopant atoms are activated in an anneal in an oven. A thin thermal silicon oxide of 7.5 nm forms the gate oxide. Then a polysilicon layer is deposited and patterned, which forms the gate region 9. In Fig. 11c the gate length is 0.5 µm. The lightly doped source and drain regions are formed self-aligned to the gate by implantation of As or P ions under an angle relative to the gate. A TEOS layer is deposited from which spacers are formed.

The heavily doped source and drain areas are implanted with As ions with a dose of 4x 10¹⁵ at/cm² and an energy of 100 keV. After annealing, the source and drain regions typically have a depth of 120 nm. The source region 7 is at least substantially positioned in the n-well 11 of the photodiode in order to reduce the n+ source- p-well junction area. There is a distance 13 between the source 7 and the p-well 10. The distance 13 between the source 7 and p-well 10 largely determines the depletion layer width.

In Fig. 11d an alternative for step Fig. 11 a is shown, in which the photosensitive element is formed almost entirely below the field isolation 23. The cross section is taken along the line A-A' in Figure 8a. The photosensitive element 5 is formed by implantation of the ions of the second conductive type (e.g. As or P) through the field isolation 23. The dashed lines of the LOCOS indicates the LOCOS seen at the background. There is a small active area formed in the LOCOS in which later the source region is formed. The position of the n-well below the LOCOS has the advantage that the dangling bonds, which are usually present at the surface, form SiO₂ bonds so that the leakage current due to dangling bonds can be reduced significantly. The leakage current can even further be reduced with annealing in an atmosphere containing hydrogen in order to passivate the remaining dangling bonds.

In Fig. 11e the n-type photosensitive element 5 has an edge 15 formed by the field oxide 23 (dashed LOCOS line at the background) and the gate 9 is positioned along that edge. The source region 7 is entirely located in the n-well of the photodiode. This even further reduces the leakage current. Usually the source region is made as small as possible, but sufficiently large to form a contact on this source region. The contact can be a tungsten plug having a diameter of e.g. 0.4 µm.

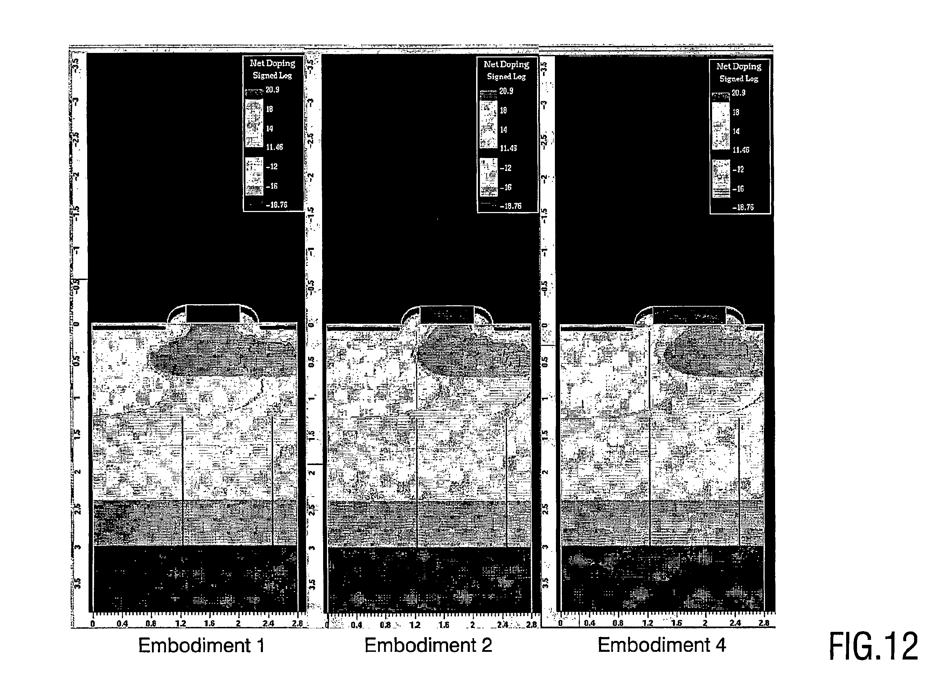

The results after these manufacturing steps are shown in Fig. 12. The dopant profiles are shown for the embodiments 1, 2 and 4 already described here above.

In the first embodiment the distance between the gate region 9 and the n-well 11 of the photodiode was 0.5 µm on the mask.

In the second embodiment the distance between the gate region 9 and the n-well 11 of the photodiode was 0 µm on the mask.

In the fourth embodiment the gate region 9 only partly overlapped the p-well region 10. The distance between the edge of the gate and the side-wall 14 of the p-well was 0.3 µm on the mask (in the length direction of the gate).

In the embodiments the junction between the source and the p-well is indicated with a white solid line. The concentration of As in the source is 10²⁰ at/cm³ and the concentration of boron in the p-well is about 2x10¹⁷ at/cm³. Due to the distance 13 between the n+ source and the p-well in all embodiments, there is no overlap between the source and the p-well. This greatly reduces the leakage current across the n+ source and p-well junction.

## Claims

1. An image sensor comprising a semiconductor body (2) having a first conductivity type and having a surface (3), the surface being provided with a number of cells (4), a cell comprising a photosensitive element (5) and a reset **MOS** transistor (6),
the reset MOS transistor comprising a source region (7), a drain region (8) and a gate region (9), the source region and the drain region having a second conductivity type opposite to the first, wherein a well region (10) **of the reset MOS transistor** is present **having a first conductivity type** which
well region extends from the surface into the semiconductor body and extends partly below the gate region the drain region extends in the well region and a separation distance (13) is present between the well region and the source region, **the source region of the reset transistor being electrically connected to the photosensitive element owing to the fact that** the source region extends at least substantially in the doped region (11) of the photosensitive element,
**characterized in that the photosensitive element (5) is a photodiode formed by a doped region (11) having a second conductivity type surrounded by the semiconductor body (2) having the first conductivity type and there is a separation distance between the doped region (11) and the well region (10), the separation distance being formed by the semiconductor body.**

2. An image sensor as claimed in claim 1, wherein the source region (7) has a bottom area (12) being at least partly delineated by the semiconductor body.

3. An image sensor as claimed in claim 1, wherein the gate region (9) extends over a side-wall of the well region (10).

4. An image sensor as claimed in claim 1, wherein the gate (9) is positioned along an edge of the photosensitive element (5).

5. An image sensor as claimed in claim 4, wherein a source follower transistor (16) is present having a gate connected to the source of the reset transistor (6), the gate of the reset transistor having a length which is longer than the length of the gate of the source follower transistor.

6. A camera system comprising the image sensor as claimed in any of the preceding claims.

## Patentansprüche

1. Bildsensor mit einem Halbleiterkörper (2) von einem ersten Leitfähigkeitstyp und einer Oberfläche (3), die mit einer Anzahl von Zellen (4) versehen ist, wobei eine Zelle ein lichtempfindliches Element (5) und einen Reset-MOS-Transistor (6) enthält, der Reset-MOS-Transistor eine Source-Region (7), eine Drain-Region (8) und eine Gate-Region (9) enthält, die Source-Region und die Drain-Region von einem zweiten Leitfähigkeitstyp sind, der dem ersten entgegengesetzt ist, und wobei eine Wannenregion (10) des Reset-MOS-Transistors von einem ersten Leitfähigkeitstyp vorhanden ist, die sich von der Oberfläche in den Halbleiterkörper hinein erstreckt und teilweise unter der Gate-Region verläuft, wobei die Drain-Region in der Wannenregion verläuft und ein Trennungsabstand zwischen der Wannenregion und der Source-Region vorhanden ist, wobei die Source-Region des Reset-Transistors elektrisch mit dem lichtempfindlichen Element verbunden ist aufgrund der Tatsache, dass die Source-Region zumindest im Wesentlichen in der dotierten Region (11) des lichtempfindlichen Elements verläuft, **dadurch gekennzeichnet, dass** das lichtempfindliche Element (5) eine Fotodiode ist, die durch eine dotierte Region (11) von einem zweiten Leitfähigkeitstyp gebildet wird, welche von dem Halbleiterkörper (2) vom ersten Leitfähigkeitstyp umgeben ist, und dass es einen Trennungsabstand zwischen der dotierten Region (11) und der Wannenregion (10) gibt, wobei der Trennungsabstand durch den Halbleiterkörper gebildet wird.

2. Bildsensor nach Anspruch 1, wobei die Source-Region (7) einen unteren Bereich (12) hat, der zumindest teilweise durch den Halbleiterkörper begrenzt wird.

3. Bildsensor nach Anspruch 1, wobei sich die Gate-Region (9) über eine Seitenwand der Wannenregion (10) erstreckt.

4. Bildsensor nach Anspruch 1, wobei die Gate-Region (9) an einem Rand des lichtempfindlichen Elements (5) entlang angeordnet ist.

5. Bildsensor nach Anspruch 4, wobei ein Source-Folger-Transistor (16) vorhanden ist, dessen Gate-Region mit der Source-Region des Reset-Transistors (6) verbunden ist, wobei die Gate-Region des Reset-Transistors länger ist als die Gate-Region des Source-Folger-Transistors.

6. Kamerasystem mit dem Bildsensor nach einem der vorhergehenden Ansprüche.

## Revendications

1. Capteur d'image comprenant un corps semi-conducteur (2) ayant un premier type de conductivité et ayant une surface (3), la surface étant dotée d'un certain nombre de cellules (4), une cellule comprenant un élément photosensible (5) et un transistor de remise à zéro MOS (6),
le transistor de remise à zéro MOS comprenant une région de source (7), une région de drain (8) et une région de grille (9), la région de source et la région de drain ayant un second type de conductivité opposé au premier, dans lequel une région de puits (10) du transistor de remise à zéro MOS est présente,
ayant un premier type de conductivité, laquelle région de puits s'étend à partir de la surface dans le corps semi-conducteur et s'étend partiellement en dessous de la région de grille, la région de drain s'étend dans la région de puits et une distance de séparation (13) est présente entre la région de puits et la région de source, la région de source du transistor de remise à zéro étant électriquement connectée à l'élément photosensible compte tenu du fait que la région de source s'étend au moins sensiblement dans la région dopée (11) de l'élément photosensible,
**caractérisé en ce que** l'élément photosensible (5) est une photodiode formée par une région dopée (11) ayant un second type de conductivité entourée par le corps semi-conducteur (2) ayant le premier type de conductivité et qu'il y a une distance de séparation entre la région dopée (11) et la région de puits (10), la distance de séparation étant formée par le corps semi-conducteur.

2. Capteur d'image selon la revendication 1, dans lequel la région de source (7) présente une zone inférieure (12) qui est au moins partiellement délimitée par le corps semi-conducteur.

3. Capteur d'image selon la revendication 1, dans lequel la région de grille (9) s'étend sur une paroi latérale de la région de puits (10).

4. Capteur d'image selon la revendication 1, dans lequel la grille (9) est positionnée le long d'un bord de l'élément photosensible (5).

5. Capteur d'image selon la revendication 4, dans lequel un transistor suiveur de source (16) est présent avec une grille raccordée à la source du transistor de remise à zéro (6), la grille du transistor de remise à zéro ayant une longueur qui est plus longue que la longueur de la grille du transistor suiveur de source.

6. Système de caméra comprenant le capteur d'image selon l'une quelconques des revendications précédentes.
